# EUROPÄISCHE PATENTSCHRIFT

(11) **EP 1 523 695 B1**
(45) Veröffentlichungstag und Bekanntmachung des Hinweises auf die Patenterteilung: **19.09.2007**
(21) Anmeldenummer: 03764969.6
(22) Anmeldetag: 10.07.2003
(51) Int. Cl.: G03D 5/04, B05C 5/00

(54) **DUESENANORDNUNG ZUM AUFBRINGEN EINER FLUESSIGKEIT AUF EIN SUBSTRAT**
NOZZLE ASSEMBLY FOR APPLYING A LIQUID TO A SUBSTRATE
SYSTEME DE BUSES POUR APPLIQUER UN LIQUIDE SUR UN SUBSTRAT

(30) Priorität: 19.07.2002 DE 10232984
(43) Veröffentlichungstag der Anmeldung: 20.04.2005
(73) Patentinhaber: Steag HamaTech AG, 75447 Sternenfels (DE); Infineon Technologies AG, 81541 München (DE)
(72) Erfinder: SCHWERSENZ, Anatol, 74821 Mosbach (DE); SAULE, Werner, 81735 München (DE); NÖRING, Andreas, 78315 Radolfzell (DE); DRESS, Peter, 76646 Bruchsal (DE); BÜRGEL, Christian, 81243 München (DE); TSCHINKL, Martin, 81243 München (DE); STROBL, Marlene, 01326 Dresden (DE)
(74) Vertreter: Wagner & Geyer
(86) Internationale Anmeldenummer: PCT/EP2003/007494
(87) Internationale Veröffentlichungsnummer: WO 2004/010220

(56) Entgegenhaltungen:
- US-B1- 6 364 547
- PATENT ABSTRACTS OF JAPAN vol. 1999, no. 01, 29. Januar 1999 (1999-01-29) & JP 10 270336 A (YUASA SEISAKUSHO:KK), 9. Oktober 1998 (1998-10-09)

## Beschreibung

Die vorliegende Erfindung bezieht sich auf eine Düsenanordnung zum Aufbringen einer Flüssigkeit auf ein Substrat.

Bei vielen Anwendungen, insbesondere in der Wafer- und Maskenherstellung ist es notwendig, zur Behandlung eines Substrats eine Flüssigkeitsschicht, wie beispielsweise einen Entwickler auf einen Wafer oder eine Maske aufzubringen.

Dies wurde in der Vergangenheit durch eine einzelne, auf das Substrat gerichtete Düse erreicht, die rasterartig über die Maske oder den Wafer gescannt bzw. überstrichen wurde, um die gesamte Substratoberfläche zu benetzen. Alternativ wurde in Betracht gezogen, mehrere nebeneinander angeordnete Düsen zu verwenden, welche auf die Substratoberfläche gerichtet sind und innerhalb eines einzelnen Überstreichvorgangs das gesamte Substrat benetzen.

Wenn die aufgebrachte Flüssigkeit beispielsweise eine Entwicklerflüssigkeit ist, die für mikrolithographische Entwicklungsschritte verwendet wird, ist es für die Qualität des Endproduktes wichtig, dass der gleiche Prozessfortschritt - d.h. der gleiche Entwicklungsgrad - auf jeder Teilfläche der zu behandelnden Substratoberfläche gewährleistet ist. Der Prozessfortschritt wird im Wesentlichen durch die Menge der aufgebrachten Entwicklerflüssigkeit, die Verweilzeit auf dem Substrat, und die mechanische Auftragskraft der Flüssigkeit auf die Substratoberfläche bestimmt. Für einen möglichst homogenen Prozessfortschritt ist es daher erforderlich, die Entwicklerflüssigkeit möglichst gleichzeitig, homogen und kräftefrei auf die gesamte Substratoberfläche aufzubringen.

Beim Aufbringen der Flüssigkeit über eine einzelne Düse müßte, um ein möglichst gleichzeitiges Aufbringen zu gewährleisten, die Fließgeschwindigkeit des Mediums sowie die Scangeschwindigkeit der Düse sehr hoch gewählt werden, da es sonst zu einer großen zeitlichen Inhomogenität beim Medienauftrag kommen würde. Die hohe Fliessgeschwindigkeit führt jedoch zu einer hohen mechanischen Auftragskraft beim Aufbringen des Mediums, was vermieden werden sollte. Darüber hinaus kommt es bei der Verwendung einer einzelnen Düse zu einer Ausprägung eines Düsenmusters auf der Substratoberfläche, da das Medium in der Regel über die Breite eines Aufbringbereichs der Düse nicht gleichmäßig - sowohl hinsichtlich der Auftragskraft als auch der Menge der aufgebrachten Flüssigkeit - aufgebracht wird.

Bei der Verwendung einer Vielzahl von nebeneinander angeordneten Düsen lässt sich die Aufbringzeit gegenüber einer einzelnen Düse erheblich verringern, wodurch eine zeitliche Inhomogenität beim Medienauftrag reduziert werden kann. Jedoch ist es weiterhin erforderlich, hohe Fliessgeschwindigkeiten zu verwenden, um ein möglichst gleichzeitiges Aufbringen des Mediums zu ermöglichen, wodurch sich wiederum eine hohe mechanische Auftragskraft beim Aufbringen des Mediums ergibt. Darüber hinaus kommt es wiederum zu der oben beschriebenen Ausprägung der einzelnen Düsen.

Aus US 6,364,547 ist ferner eine Düsenanordnung zum Aufbringen einer Fotoresistlösung auf einen Halbleiterwafer bekannt. Diese Düsenanordnung weist einen Düsenkörper mit einer Vorderseite auf, in der entlang einer geraden Linie eine Vielzahl von Auslassanschlüssen vorgesehen ist. An der Vorderseite des Düsenkörpers ist über eine obere Tragplatte eine Führungs- oder Umlenkplatte angebracht. Dabei besitzt die Tragplatte einen sich im Wesentlichen horizontal erstreckenden Teil, an dessen freien, vom Düsenkörper beabstandeten Ende sich die Umlenkplatte nach unten erstreckt. Dabei erstreckt sich die zu der Vorderseite weisende Seite der Umlenkplatte nicht parallel zu der Vorderseite des Düsenkörpers sondern unter einem Winkel hierzu. Durch die Anbringung der Umlenkplatte über die obere Tragplatte ist die Umlenkplatte von der Vorderseite des Düsenkörpers beabstandet, so dass sich ein Abstand von 5 - 10 mm zwischen den Auslassanschlüssen und der Umlenkplatte ergibt.

Ausgehend von dem obigen Stand der Technik liegt der vorliegenden Erfindung die Aufgabe zugrunde, eine Vorrichtung vorzusehen, die ein rasches, homogenes und möglichst kräftefreies Aufbringen einer Flüssigkeit auf ein Substrat ermöglicht.

Erfindungsgemäß wird diese Aufgabe durch eine Düsenanordnung gemäß Anspruch 1 gelöst. Weitere Ausführungsformen der Erfindung ergeben sich aus den Unteransprüchen.

Insbesondere ist bei einer Düsenanordnung zum Aufbringen einer Flüssigkeit auf ein Substrat vorgesehen, dass die Düsenanordnung einen Düsenkörper mit einer Vielzahl von im Wesentlichen auf einer Linie angeordneten Düsen und eine sich im Wesentlichen vertikal erstreckende Umlenkplatte mit einer geraden Unterkante aufweist. Dabei sind die Düsen oberhalb der Unterkante auf die Umlenkplatte gerichtet, so dass sich ein Flüssigkeitsfilm auf der Umlenkplatte bildet, der über die Unterkante abfließt. Zwischen Düsenkörper und Umlenkplatte wird ein sich nach unten erweiternder Spalt gebildet wird, der durch eine ebene Fläche des Düsenkörpers und die ebene Fläche der Umlenkplatte gebildet wird, die unter einem spitzen Winkel zwischen 0,5° und 4°zueinander angeordnet sind. Die Ebenen der Flächen schneiden sich oberhalb der Düsenanordnung im Bereich des Düsenkörpers. Bei einer derartig aufgebauten Vorrichtung kann ein im Wesentlichen homogener Flüssigkeitsfilm auf der Umlenkplatte ausgebildet werden, der als homogener Film auf das zu benetzende Substrat aufgebracht werden kann. Ferner kann der Film mit einer gleichmäßigen Auftragskraft auf die Substratoberfläche aufgebracht werden, da keine Ausprägung einzelner Düsen auf der Substratoberfläche erfolgt. Darüber hinaus kann der Flüssigkeitsfilm rasch durch eine einzelne Relativbewegung zwischen Substrat und Vorrichtung aufgebracht werden. Obwohl hierbei auch hohe Fliessgeschwindigkeiten der Flüssigkeit erreicht werden müssen, erhöht sich hierdurch nicht oder zumindest nicht wesentlich die auf die Substratoberfläche wirkende Kraftkomponente. Die mechanische Aufbringkraft ist im Wesentlichen unabhängig von der Fliessgeschwindigkeit durch die Düsen und wird im Wesentlichen durch eine Laufstrecke auf der Umlenkplatte und eine Falltiefe zwischen Unterkante der Umlenkplatte und Substratoberfläche bestimmt.

Um die Vorrichtung auf unterschiedliche Flüssigkeiten mit unterschiedlichen Viskositäten einzustellen, ist der Winkel vorzugsweise einstellbar. Hierdurch kann eine homogene Ausbildung des Flüssigkeitsfilms in Abhängigkeit von der Flüssigkeit erreicht werden. Vorzugsweise liegt der Winkel in einem Winkelbereich zwischen 1° und 3°, bzw. zwischen 1,5° und 2,5 °.

Bei einer Ausführungsform der Erfindung erstreckt sich die ebene Fläche der Umlenkplatte über die ebene Fläche des Düsenkörpers hinweg nach unten. Hierdurch wird sichergestellt, dass der Flüssigkeitsfilm sauber an der Unterkante der Umlenkplatte abreißen kann und dieser Abriss nicht durch den Düsenkörper beeinflusst wird.

Für einen einfachen Aufbau der Vorrichtung ist die Umlenkplatte direkt am Düsenkörper angebracht. Hierdurch wird insbesondere ermöglicht, dass die Umlenkplatte und der Düsenkörper als Einheit bewegt werden können. Dabei ist die Umlenkplatte vorzugsweise oberhalb der Düsen am Düsenkörper angebracht, um in einem Bereich unterhalb der Düsen Anbringungselemente zu vermeiden, welche die Homogenität des Flüssigkeitsfilms auf der Umlenkplatte beeinflussen könnten.

Um zu verhindern, dass sich die aus den Düsen austretende Flüssigkeit zwischen Umlenkplatte und Düsenkörper hindurch nach oben bewegt, und dadurch gegebenenfalls die Homogenität des Flüssigkeitsfilms beeinträchtigt, ist vorzugsweise eine oberhalb der Düsen liegende Dichtung zwischen Düsenkörper und Umlenkplatte vorgesehen. Dabei ist vorzugsweise eine Ausnehmung am Düsenkörper vorgesehen, die eine zur Form der Dichtung komplementäre Form aufweist. Hierdurch wird eine sichere Anordnung und ein guter Halt der Dichtung sichergestellt. Vorzugsweise weist die Dichtung einen runden Querschnitt auf.

Gemäss einer besonders bevorzugten Ausführungsform der Erfindung werden die Düsen durch gerade Durchlässe im Düsenkörper gebildet, wobei ein Einlassende des Durchlasses höhenmäßig unterhalb eines Auslassendes liegt. Hierdurch wird verhindert, dass dann, wenn die Vorrichtung nicht in Betrieb ist, d.h. keine Flüssigkeit fließt, Flüssigkeit aus den Düsen tropft und hierdurch Blasen in das Flüssigkeitssystem eintreten. Derartige Blasen würden eine kontinuierliche und vollständige Benetzung der Substratoberfläche beeinträchtigen. Vorzugsweise münden die Einlassenden der Düsen in eine gemeinsame Verteilerleitung, die einen wesentlich größeren Querschnitt als die jeweiligen Düsen aufweist. Hierdurch wird eine im Wesentlichen gleichmäßige Fließgeschwindigkeit über die Düsen hinweg sichergestellt.

Um zu verhindern, dass bei abgeschaltetem System ein Flüssigkeitsdruck an den Düsen ansteht, was zu einem Auslaufen von Flüssigkeit führen könnte, liegen die Einlassenden der Düsen an oder in der Nähe des höchsten Punktes der Verteilerleitung.

Bei einer bevorzugten Ausführungsform der Erfindung ist für eine möglichst homogene Druckverteilung innerhalb der Verteilerleitung vorzugsweise eine unterhalb der Verteilerleitung liegende Versorgungsleitung vorgesehen, die über eine Vielzahl von Verbindungsleitungen mit der Verteilerleitung verbunden ist. Das Vorsehen der Vielzahl von Verbindungsleitungen ermöglicht eine homogene Druckverteilung innerhalb der Verteilerleitung und somit eine homogene Druckverteilung über die Düsen hinweg. Dadurch, dass die Versorgungsleitung unterhalb der Verteilerleitung liegt, wird wiederum sichergestellt, dass bei abgeschaltetem System kein Druck auf die in den Düsen befindliche Flüssigkeit ausgeübt wird. Außerdem ermöglicht der Aufbau des Flüssigkeitssystems aus Versorgungsleitung, Verteilerleitung und schrägen Düsen, dass sich das System beim Befüllen gegen die Schwerkraft automatisch entlüftet. Darüber hinaus ist ein Auslaufen der Düsen nur gegen die Schwerkraftwirkung möglich und wird somit im Wesentlichen ausgeschlossen. Hierdurch kann auch nach längerem Abschalten des Flüssigkeitssystems nach einem Neustart sofort wieder ein homogener Flüssigkeitsfilm bereitgestellt werden, da das Flüssigkeitssystem immer gleichmäßig mit Flüssigkeit befüllt ist und keine Luftblasen darin eintreten können.

Für eine gleichmäßige Druckverteilung innerhalb der Verteilerleitung, sind die Verbindungsleitungen zwischen Versorgungsleitung und Verteilerleitung über die Länge der Verteilerleitung hinweg vorzugsweise gleichmäßig beabstandet.

Um die homogene Ausbildung des Flüssigkeitsfilms auf der Umlenkplatte zu fördern, ist vorzugsweise wenigstens die zu den Düsen weisende Oberfläche der Umlenkplatte aus einem hydrophilen Material gefertigt.

Um eine vollständige Benetzung einer Substratoberfläche zu ermöglichen, ist vorzugsweise eine Einrichtung zum Erzeugen einer Relativbewegung zwischen Substrat und Umlenkplatte vorgesehen. Dabei weist die Einrichtung vorzugsweise eine Einheit zum Bewegen der Umlenkplatte im Wesentlichen parallel zur Oberfläche des Substrats auf, um eine gleichmäßige mechanische Auftragskraft über das Substrat hinweg vorzusehen.

Bei einer Ausführungsform der Erfindung ist die Einrichtung eine Linear-Bewegungseinheit zum Bewegen des Substrats und/oder des Düsenkörpers mit der Umlenkplatte. Bei einer alternativen Ausführungsform ist der Düsenkörper und die Umlenkplatte an einem schwenkbaren Arm angebracht, wobei ein möglichst großer Schwenkradius gewählt wird, um Inhomogenitäten infolge der Schwenkbewegung zu verhindern.

Um eine gute und gleichmäßige Benetzung des Substrats sicherzustellen, ist die Umlenkplatte vorzugsweise breiter als das Substrat. Dies ist insbesondere von Vorteil, da der Flüssigkeitsfilm in den Randbereichen der Umlenkplatte Inhomogenitäten aufweist.

Um einen der Breite des Substrats entsprechenden homogenen Flüssigkeitsfilm zu bilden, weisen die äußersten Düsen im Düsenkörper vorzugsweise einen Abstand dazwischen auf, der größer ist als die Breite des Substrats.

Bei einer bevorzugten Ausführungsform der Erfindung ist eine Einrichtung zum Einstellen eines Abstands zwischen der Unterkante der Umlenkplatte und dem Substrat vorgesehen. Hierdurch läßt sich die Fallhöhe des Flüssigkeitsfilms verändern, um die Auftragskraft der Flüssigkeit auf das Substrat einzustellen. Bei einer weiteren Ausführungsform der Erfindung ist die Unterkante der Umlenkplatte eine spitze Kante, um eine definierte Abrisskante an der Unterkante der Umlenkplatte vorzusehen. Hierdurch wird ein definiertes Ablaufen des Flüssigkeitsfilms sichergestellt und es wird verhindert, dass sich die Fließrichtung der Flüssigkeit beim Verlassen der Umlenkplatte verändert.

Um die Breite des Flüssigkeitsfilms in Abhängigkeit von den zu benetzenden Substraten einzustellen, ist vorzugsweise eine Einrichtung zum Öffnen und Schließen vorbestimmter Düsen, insbesondere der außenliegenden Düsen vorgesehen.

Für eine homogene Ausbildung des Flüssigkeitsfilms wird zwischen den Düsen und der Umlenkplatte vorzugsweise ein Winkel von 90° bis 94° gebildet. Gute Prozessergebnisse lassen sich insbesondere in einem Winkelbereich zwischen 90,5° und 93° bzw. zwischen 90,5° und 92° erreichen.

Die erfindungsgemäße Vorrichtung ist insbesondere für die Anwendung in der Wafer- und Maskenherstellung geeignet, bei der sehr feine Strukturen bearbeitet werden müssen und bei der extrem homogene Prozessverhältnisse herrschen müssen.

Die Erfindung wird nachfolgend anhand eines bevorzugten Ausführungsbeispiels unter Bezugnahme auf die Zeichnungen näher erläutert. Es zeigen:
- Fig. 1: eine schematische Draufsicht auf eine Vorrichtung zum Behandeln von Masken für die Waferherstellung, mit einer Düsenanordnung gemäß der vorliegenden Erfindung;
- Fig. 2: eine schematische Vorderansicht auf einen Düsenkörper gemäß der vorliegenden Erfindung;
- Fig. 3: eine schematische Schnittansicht durch den Düsenkörper gemäß Fig. 2;
- Fig. 4: eine schematische Seitenansicht einer Düsenanordnung gemäß der vorliegenden Erfindung;
- Fig. 5: eine schematische Teilschnittansicht durch eine Düsenanordnung gemäß der vorliegenden Erfindung;
- Fig. 6: eine schematische Vorderansicht auf eine Düsenanordnung gemäß der Erfindung.

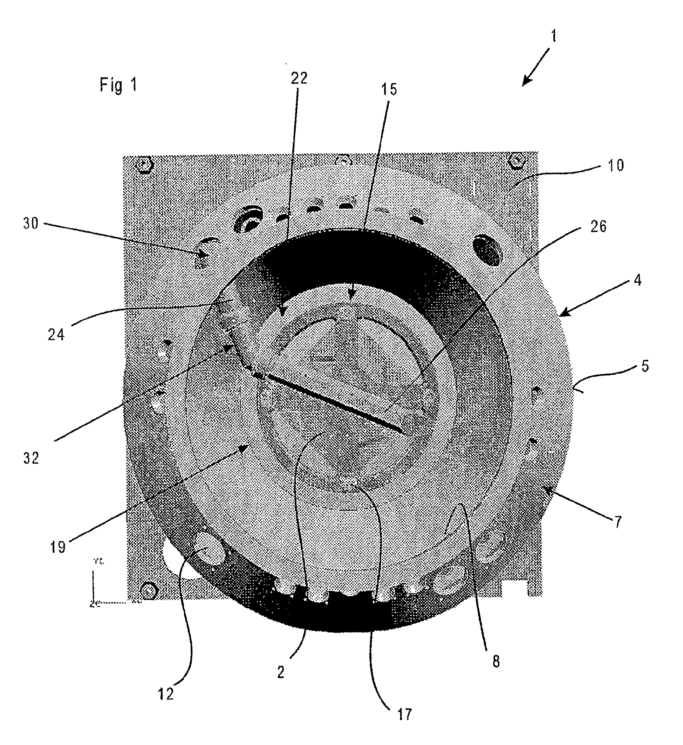

Fig. 1 zeigt eine schematische Draufsicht auf eine Vorrichtung 1 zum Behandeln von Masken 2 für die Herstellung von Halbleiterwafern. Die Vorrichtung 1 besitzt einen Behandlungsbehälter 4 mit einer Seitenwand 5, die sich wenigstens in einem oberen Bereich 7 konisch verjüngt und eine obere, runde Eingabe/Ausgabeöffnung 8 bildet. Der Boden des Behandlungsbehälters 4 wird durch eine entsprechende Bodenplatte gebildet, die gemeinsam mit der Seitenwand 5 an einer Befestigungsplatte 10 befestigt ist. Die obere Eingabe/Ausgabeöffnung 8 ist durch einen entsprechenden, nicht näher dargestellten Deckel verschließbar. In dem konischen Teil 7 der Seitenwand 5 ist eine Vielzahl von Durchführlöchern 12 für die Durchführung unterschiedlicher Behandlungssysteme, insbesondere Zuleitungen für unterschiedliche Flüssigkeiten, vorgesehen.

Im Inneren des Behandlungsbehälters 4 ist eine drehbare Aufnahmeeinrichtung 15 vorgesehen, die gemäß Fig. 1 vier Auflageelemente 17 aufweist. Die Aufnahmeeinrichtung 15 ist über eine sich durch die Bodenwand des Behälters erstreckende Drehwelle und einen geeigneten Antrieb drehbar. Dabei ist die Aufnahmeeinrichtung 15 dynamisch derart balanciert, dass sie hohe Drehzahlen ermöglicht.

Unterhalb der Aufnahmeeinrichtung 15 ist eine Dichtungsbalg 19 vorgesehen, der die Drehwelle der Aufnahmeeinrichtung 15 gegenüber der Prozessumgebung abdichtet. Neben der Dichtungsfunktion besitzt der Balg, der beispielsweise als Blasebalg ausgeführt sein kann, die Funktion, die Aufnahmeeinrichtung senkrecht zur Blattebene der Fig. 1 zu verschieben. Diese Funktion kann natürlich auch durch eine andere geeignete Vorrichtung erreicht werden.

In Fig. 1 ist ferner eine erfindungsgemäße Düsenanordnung 22 zu erkennen, die bei der Darstellung in Fig. 1 teilweise oberhalb der Maske 2 angeordnet ist.

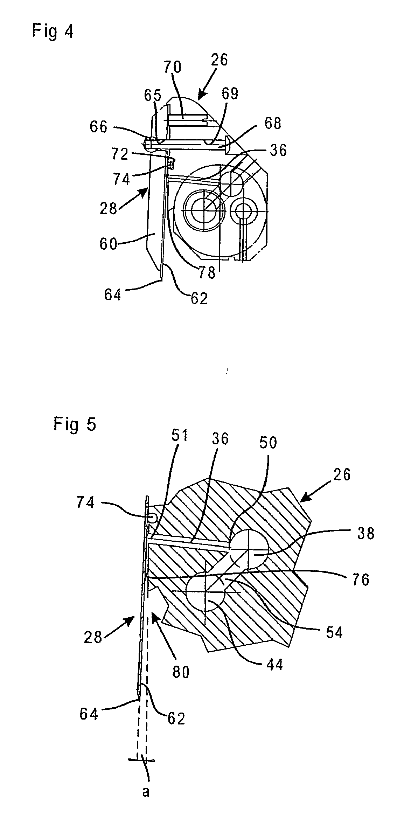

Die Düsenanordnung 22 besteht aus einer Zuleitung 24, einem Düsenkörper 26 und einer in Fig. 1 nicht sichtbaren Umlenkplatte 28, die am Besten in Fig. 4 zu erkennen ist.

Die Zuleitung 24 besitzt einen sich im Wesentlichen senkrecht zur Blattebene der Fig. 1 erstreckenden Rohrabschnitt 30, der in geeigneter Weise mit einer Schwenkeinrichtung verbunden ist, um die Zuleitung 24 um eine sich senkrecht zur Blattebene erstreckende Schwenkachse im Bereich des Abschnitts 30 zu schwenken. Die Zuleitung 24 besitzt ferner einen Abschnitt, der sich im Wesentlichen in der Blattebene gemäß Fig. 1 erstreckt und einen Auslegerarm 32 bildet. An seinem freien Ende trägt der Auslegerarm 32 in geeigneter Weise den Düsenkörper 26. Der Düsenkörper 26 wird durch einen geraden langgestreckten Körper gebildet, der sich mit einem Winkel bezüglich einer Haupterstreckungsrichtung des Auslegerarms 32 erstreckt. Dadurch, dass die Zuleitung 24 im Bereich des Abschnitts 30 schwenkbar ist, kann der Düsenkörper 26 aus einem Bereich, in dem er nicht über der Maske 2 angeordnet ist, in einen Bereich oberhalb der Maske und über die Maske hinweg geschwenkt werden. Der Winkel zwischen der Haupterstreckungsrichtung des Auslegerarms 32 und dem Düsenkörper 26 ermöglicht dabei einen größeren Schwenkbereich. Dies ermöglicht, dass die Maske 2 in einer Richtung senkrecht zur Blattebene der Fig. 1 gerichteten Richtung aus dem Behandlungsbehälter 4 herausgehoben werden kann. Dies ist erforderlich, damit ein externer Handhabungsroboter auf die Maske 2 zugreifen kann, um diese von der Aufnahmeeinrichtung 15 zu entnehmen bzw. eine neue Maske hierauf abzulegen.

Das Verschwenken des Düsenkörpers 26 ermöglicht ferner das vollständige Benetzen der Maske 2, wie nachfolgend noch näher beschrieben wird.

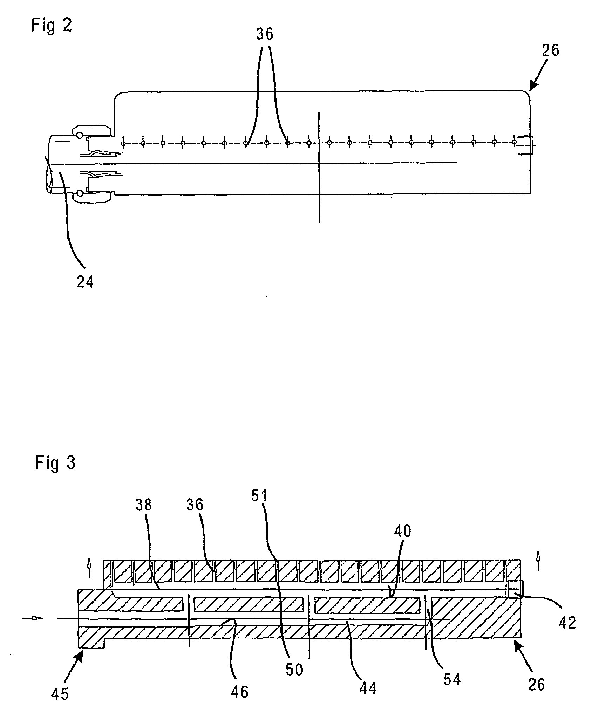

Fig. 2 zeigt eine schematische Vorderansicht des Düsenkörpers 26 ohne Umlenkplatte 28 und Fig. 3 zeigt eine schematische Schnittansicht durch den Düsenkörper 26, ebenfalls ohne daran angebrachte Umlenkplatte 28. Wie in den Fig. 2 und 3 zu erkennen ist, sind in dem Düsenkörper 26 insgesamt 20 Düsen 36 vorgesehen, die auf einer geraden Linie angeordnet sind. Die Düsen 36 sind jeweils durch entsprechende gerade Bohrungen im Düsenkörper 26 ausgebildet. Die Düsen 36 stehen mit einer sich senkrecht zu den Düsen 36 erstreckenden Verbindungsleitung 38 in Verbindung, die durch eine gerade Sackbohrung 40 im Düsenkörper 26 ausgebildet ist. Die Sackbohrung 40 erstreckt sich von einem der Zuleitung 24 entfernten Ende in den Düsenkörper 26. Das offene Ende der Sackbohrung 40 ist durch einen geeigneten Stopfen 42 verschlossen.

Alternativ könnte sich die Bohrung 40 auch durch den Düsenkörper 26 hindurch erstrecken und die gegenüberliegenden Öffnungen könnten jeweils in geeigneter Weise verschlossen sein. Beispielsweise könnten die gegenüberliegenden Enden jeweils mit einem Gleitschieber verschlossen sein, der es ermöglicht, eine Verbindung zwischen Verteilungsleitung 38 und den am weitesten außen liegenden Düsen 36 zu blockieren, um hierdurch graduell die Anzahl der mit Flüssigkeit beaufschlagten Düsen 36 zu verringern. Eine derartige Verringerung der Anzahl der eingesetzten Düsen kann im Fall der Sackbohrung von einer Seite her erfolgen oder im Fall einer Durchgangsbohrung von beiden Seiten, um eine verbesserte Symmetrie zu erhalten.

Im Düsenkörper 26 ist ferner eine Versorgungsleitung 44 vorgesehen, die durch eine entsprechende Sackbohrung 46 gebildet wird. Obwohl dies in Fig. 3 nicht zu erkennen ist, liegt die Versorgungsleitung 44 höhenmäßig unter der Verteilerleitung 38. Darüber hinaus, stehen die Düsen 36 an oder in der Nähe eines höchsten Punktes der Verteilerleitung mit dieser in Verbindung. Ferner steigen die Düsen 36 bei einer normalen Ausrichtung des Düsenkörpers 26 bezüglich der Horizontalen an, d.h., dass sie ein mit der Verteilerleitung 38 kommunizierendes Einlassende 50 aufweisen, das bezüglich ihrem Auslassende 51 tiefer liegt. Diese Merkmale der geometrischen Anordnung der Versorgungsleitung 44, der Verteilerleitung 38 und der Düsen 36 ergibt sich im Wesentlichen auch aus der schematischen Seitenansicht gemäß Fig. 4 bzw. der schematischen Teilschnittansicht gemäß Fig. 5.

Die Versorgungsleitung 44 ist über geeignete Verbindungsleitungen 54 mit der Verteilerleitung 38 verbunden. Die Verbindungsleitungen 54 sind bezüglich der Länge der Verteilerleitung 38 gleichmäßig beabstandet und bezüglich einer Mittelebene symmetrisch angeordnet, um eine möglichst gleichmäßige Druckverteilung innerhalb der Verteilerleitung 38 zu erreichen.

Statt die Versorgungsleitung 44 durch eine sich seitlich in den Düsenkörper 26 erstreckende Sackbohrung mit einem seitlichen Anschlussende 45 vorzusehen, ist es auch möglich, einen im Wesentlichen mittigen Anschluss am Düsenkörper 26 vorzusehen, um eine bessere Druckverteilung innerhalb der Versorgungsleitung 44 und demgemäß innerhalb der Verteilerleitung 38 vorzusehen. Ferner würde ein mittiger Anschluss der Zuleitung 24 an den Düsenkörper 26 den Schwenkradius erhöhen.

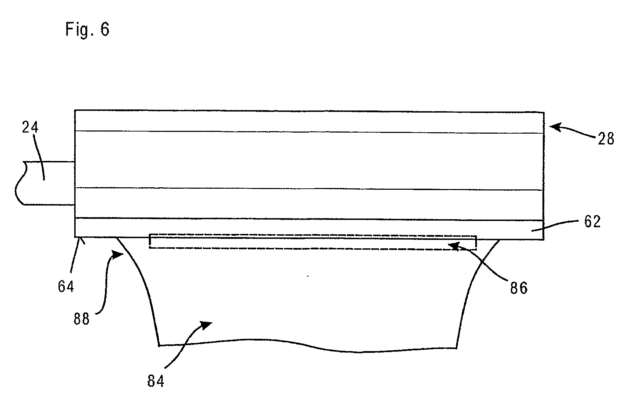

Die Figuren 4 und 5 zeigen eine schematische Seitenansicht eines Düsenkörpers 26 und einer daran angebrachten Umlenkplatte 28, bzw. eine schematische Teilschnittansicht durch den Düsenkörper 26 und die Umlenkplatte 28. Fig. 6 zeigt eine schematische Vorderansicht auf die Umlenkplatte 28 und den Düsenkörper 26.

Wie am Besten in Fig. 4 zu erkennen ist, weist die Umlenkplatte 28 eine trapezförmige Grundplatte 60 auf, die mit ihrer längeren Seite zum Düsenkörper 26 weist. Die längere Seite ist teilweise mit einer Schicht 62 aus hydrophoben Material versehen, wobei sich die Schicht 62 über ein unteres Ende des Grundkörpers 60 hinweg erstreckt, und in einer spitzen Kante 64 endet.

Der Grundkörper 60 weist eine sich senkrecht zu den Hauptseiten erstreckende Durchgangsbohrung 65 auf, die an ihrem vom Düsenkörper 26 wegweisenden Ende eine halbrunde Ausnehmung zur Aufnahme einer Kugelmutter 66 besitzt. Eine Schraube 68 erstreckt sich durch eine entsprechende Bohrung 69 des Düsenkörpers 26 und die Bohrung 65 in dem Düsenkörper 60 und ist in die Kugelmutter 66 geschraubt. Hierdurch wird die Umlenkplatte 28 am Düsenkörper 26 gehalten. Dabei ist die Umlenkplatte 28 in geringem Maße um die Kugelmutter 66 herum verschwenkbar. Der Grad der Verschwenkung wird im Wesentlichen durch ein Spiel der Schraube 68 in der Durchgangsbohrung des Grundkörpers 60 begrenzt. Der Grad der Verschwenkung wird durch eine Stellschraube 70 innerhalb des Düsenkörpers 26 eingestellt. Obwohl in Fig. 4 nur eine Befestigungsschraube 68 und eine Stellschraube 70 dargestellt sind, können über die Breite der Umlenkplatte 28 hinweg natürlich eine Vielzahl von Befestigungs- und/oder Stellschrauben vorgesehen sein.

Wie in Fig. 4 zu erkennen ist, liegen die Befestigungs- und Stellschrauben 28, 70 oberhalb der Düsen 36 und oberhalb der hydrophoben Schicht 62. Die hydrophobe Schicht 62 erstreckt sich von der Durchgangsbohrung des Grundkörpers 60 nach unten, könnte sich aber natürlich auch oberhalb der Durchgangsbohrung erstrecken. Im Düsenkörper 26 ist eine Schwalbenschwanznut 72 zur Aufnahme eines runden Dichtelements 74 vorgesehen. Die Schwalbenschwanznut 72 ist in einer zur Umlenkplatte 28 weisenden Oberfläche des Düsenkörpers 26 vorgesehen und liegt höhenmäßig zwischen den Düsen 36 und den Bohrungen zur Aufnahme der Befestigungsschrauben 68. Das in der Schwalbenschwanznut 72 aufgenommene runde Dichtelement dichtet gegen die Umlenkplatte 28 ab und verhindert, dass unter Druck stehende, aus den Düsen 36 ausströmende Flüssigkeit nach oben strömt.

Der Düsenkörper 26 besitzt unterhalb der Düsen 36 eine flache, sich im Wesentlichen senkrecht nach unten erstreckende Wand 76, die in einer unteren Kante 78 endet. Diese flache Wand bildet mit der Umlenkplatte 28 und zwar speziell mit der hydrophoben Schicht 62 einen sich nach unten erweiternden Spalt 80, wie am Besten in Fig. 5 zu erkennen ist. Der Spalt 80 bildet einen spitzen Winkel α, der vorzugsweise zwischen 0,5° und 4° liegt und über den oben genannten Stellmechanismus verändert werden kann. Dabei kann der Winkel vorzugsweise zwischen 1° und 3° bzw. zwischen 1,5° und 2,5° liegen. Der sich erweiternde Spalt ermöglicht eine gute Ausbildung eines homogenen Flüssigkeitsfilms durch aus den Düsen 36 austretende Flüssigkeit, wie nachfolgend noch näher beschrieben wird.

Die untere Kante 78 der geraden Wand 76 des Düsenkörpers 26 endet oberhalb der unteren spitzen Kante 64 der hydrophoben Schicht 62, um zu verhindern, dass der dazwischen gebildete Flüssigkeitsfilm ungleichmäßig von der Unterkante 64 abläuft.

Fig. 6 zeigt schematisch die Umlenkplatte 28 und einen daran ablaufenden Flüssigkeitsfilm 84. Der Düsenkörper 26 ist in dieser Ansicht nicht zu erkennen, da er im Wesentlichen hinter der Umlenkplatte 28 liegt. Die Umlenkplatte 28 und der dahinter liegende Düsenkörper besitzen eine Breite, die größer ist als die Breite der zu benetzenden, in Fig. 6 nicht dargestellten, Maske. Wie in Fig. 6 zu erkennen ist, besitzt der an der Umlenkplatte 28 gebildete Flüssigkeitsfilm 84 über die Breite der Umlenkplatte 28 hinweg einen homogenen mittleren Bereich 86 sowie inhomogene Randbereiche 88, die sich unter anderem daraus ergeben, dass die jeweils äußeren Düsen 36 im Düsenkörper 26 jeweils nur eine benachbarte Düse aufweisen. Die Breite des homogenen Mittelbereichs 86 des Flüssigkeitsfilms 84 entspricht wenigstens der Breite der zu benetzenden Maske, um eine homogene Beschichtung derselben sicherzustellen. Dies läßt sich dadurch erreichen, dass die Umlenkplatte 28 eine größere Breite als die zu beschichtende Maske besitzt und die äußeren Düsen 36 im Düsenkörper 26 einen Abstand besitzen, der größer ist als die Breite der Maske. Wenn die Düsenanordnung 22, wie bei der in Fig. 1 dargestellten Vorrichtung, über die Maske 2 geschwenkt wird, muss der homogene Mittelbereich natürlich eine Länge besitzen, die wenigstens der maximalen Überdeckung der Maske 2 entspricht, was durch eine entsprechende Länge der Umlenkplatte und einen entsprechenden Abstand zwischen den äußeren Düsen erreicht wird.

Der Einsatz der erfindungsgemäßen Düsenanordnung wird nachfolgend anhand der Figuren noch näher erläutert.

Zunächst wird die Düsenanordnung 22 aus einem Vertikalbewegungsbereich der Aufnahmeeinrichtung 15 herausbewegt. Anschließend wird die Aufnahmeeinrichtung 15 vertikal angehoben. Über einen nicht dargestellten Handhabungsroboter wird eine zu bearbeitende Maske 2 auf den Aufnahmeelementen 17 der Aufnahmeeinrichtung 15 abgelegt. Die Aufnahmeeinrichtung 15 wird wieder vertikal nach unten bewegt, so dass sie sich höhenmäßig unter der Düsenanordnung 22 befindet.

Eine Behandlungsflüssigkeit, wie beispielsweise eine Entwicklerflüssigkeit wird über die Zuleitung 24 in den Düsenkörper 26 eingeleitet. Dabei wird die Flüssigkeit über die Versorgungsleitung 44 eingeleitet. Die Flüssigkeit steigt von unten nach oben in der Versorgungsleitung 44 an und strömt dann über die Verbindungsleitungen 54 in die Verteilerleitung 38. Dabei steigt die Flüssigkeit entgegen der Schwerkraft an, wodurch Lufteinschlüsse in den jeweiligen Leitungen vermieden werden. Aus der Verteilerleitung 38 tritt die Flüssigkeit in die Düsen 36 ein, wobei die Düsen 36 aufgrund der Steigung der Düsen 36 von unten nach oben befüllt werden. Hierdurch werden wiederum Lufteinschlüsse in der Flüssigkeit vermieden. Lufteinschlüsse werden darüber hinaus dadurch vermieden, dass die Flüssigkeit mit hohen Druck in den Düsenkörper 26 eingeleitet wird. Wenn die Flüssigkeit aus den Austrittsenden 51 der Düsen 36 austritt, trifft sie auf die Umlenkplatte 28, insbesondere auf die hydrophile Schicht 62. Aufgrund des Drucks breitet sich die Flüssigkeit seitlich und nach unten entlang der Umlenkplatte 28 aus. Eine Ausbreitung nach oben wird durch die Dichtung 74 verhindert. Dabei entsteht ein homogener Flüssigkeitsfilm auf der hydrophoben Schicht 62, der nach unten daran abfließt. Die Homogenität der sich bildenden Flüssigkeitsschicht wird durch den sich nach unten verbreiternden Spalt 80 gefördert, der auch zu einer Beruhigung der Strömung beiträgt.

Wenn sich der nach unten abfließende Flüssigkeitsfilm 84 gebildet hat, wird die Düsenanordnung 22 über die nicht dargestellte Schwenkvorrichtung derart geschwenkt, dass der Düsenkörper mit gleichmäßiger Geschwindigkeit über die Maske 2 hinwegstreicht. Dadurch bildet der nach unten ablaufende Flüssigkeitsfilm 48 eine homogene Flüssigkeitsschicht auf der Maske 2.

Vor dem Überstreichen der Düsenanordnung über die Maske 2 wird der Abstand zwischen der Unterkante 64 der hydrophoben Schicht 62 und einer Oberseite der Maske 2 über den Balg 19 eingestellt. Dieser Abstand kann sehr gering gewählt werden, um die mechanische Aufbringkraft des Flüssigkeitsfilms 84 auf die Maskenoberfläche gering zu halten. Die Fließgeschwindigkeit der Flüssigkeit in der Düsenanordnung 22 und somit die Fließgeschwindigkeit des Flüssigkeitsfilms 84, sowie die Geschwindigkeit der Schwenkbewegung werden derart gewählt, dass eine Flüssigkeitsschicht mit geeigneter Schichtdicke auf der Maske 2 ausgebildet wird.

Nach dem Überstreichen der Düsenanordnung 22 über die Maske 2 wird der Flüssigkeitsstrom in der Düsenanordnung 22 abgeschaltet und die Düsenanordnung 22 wird in ihre Ausgangsposition, d.h. außerhalb eines Vertikalbewegungsbereich der Aufnahmeeinrichtung 15 zurückgeschwenkt. Da die Düsenanordnung 22 gegen die Schwerkraft befüllt wird, ist ein ungewolltes Auslaufen von Flüssigkeit nach dem Abschalten des Flüssigkeitsstroms nicht zu befürchten, so dass die Düsenanordnung 22 gefahrlos zurückgeschwenkt werden kann.

Anschließend wird die Maske 2 in bekannter Art und Weise weiter bearbeitet. Abschließend wird die Maske 2 wieder aus der Vorrichtung 1 entnommen.

Die Erfindung wurde zuvor anhand eines bevorzugten Ausführungsbeispiels der Erfindung beschrieben, ohne auf das konkret dargestellte Ausführungsbeispiel beschränkt zu sein. Beispielsweise ist die erfindungsgemäße Düsenanordnung auch für die Benetzung von Halbleiterwafern oder beliebige andere Substrate geeignet. Insbesondere auch bei Halbleiterwafern ist ein möglichst kräftefreies Aufbringen einer Benetzungsflüssigkeit notwendig, da die darauf ausgebildeten Bauteile, die im Nanometerbereich liegen, leicht zerstört werden können. Ferner ist das Vorsehen einer hydrophoben Schicht 62 an der Umlenkplatte 28 nicht unbedingt notwendig. Vielmehr könnte die Umlenkplatte 28 allein durch einen Grundkörper 60 gebildet werden.

## Patentansprüche

1. Düsenanordnung (22) zum Aufbringen einer Flüssigkeit auf ein Substrat, wobei die Düsenanordnung (22) einen Düsenkörper (26) mit einer Vielzahl von im Wesentlichen auf einer Linie angeordneten Düsen (36) und eine sich im Wesentlichen vertikal erstreckende Umlenkplatte (28) mit einer gerade Unterkante (64) aufweist, und wobei die Düsen (36) oberhalb der Unterkante (64) auf die Umlenkplatte (28) gerichtet sind, so dass sich ein Flüssigkeitsfilm (84) auf der Umlenkplatte (28) bildet, der über die Unterkante (64) abfließt, wobei zwischen Düsenkörper (26) und Umlenkplatte (28) ein sich nach unten erweiternder Spalt (80) gebildet wird, der durch eine ebene Fläche (76) des Düsenkörpers (26) und die ebene Fläche der Umlenkplatte (28) gebildet wird, **dadurch gekennzeichnet das** diese unter einem spitzen Winkel (α) zwischen 0,5° und 4°zueinander angeordnet sind, und wobei sich die Ebenen der Flächen oberhalb der Düsenanordnung im Bereich des Düsenkörpers schneiden.

2. Düsenanordnung (22) nach Anspruch 1, **dadurch gekennzeichnet, dass** der Winkel (α) einstellbar ist.

3. Düsenanordnung (22) nach Anspruch 1 oder 2, **dadurch gekennzeichnet, dass** der Winkel (α) zwischen 1 ° und 3° liegt.

4. Düsenanordnung (22) nach Anspruch 3, **dadurch gekennzeichnet, dass** der Winkel (α) zwischen 1,5° und 2,5° liegt.

5. Düsenanordnung (22) nach einem der Ansprüche 1 bis 4, **dadurch gekennzeichnet, dass** sich die ebene Fläche der Umlenkplatte (28) über die ebene Fläche (76) des Düsenkörpers (26) hinweg nach unten erstreckt.

6. Düsenanordnung (22) nach einem der vorhergehenden Ansprüche, **dadurch gekennzeichnet, dass** die Umlenkplatte (26) direkt am Düsenkörper (26) angebracht ist.

7. Düsenanordnung (22) nach Anspruch 6, **dadurch gekennzeichnet, dass** die Umlenkplatte (26) oberhalb der Düsen (36) am Düsenkörper (26) angebracht ist.

8. Düsenanordnung (22) nach einem der vorhergehenden Ansprüche, **gekennzeichnet durch** eine oberhalb der Düsen (36) liegende Dichtung (74) zwischen Düsenkörper (26) und Umlenkplatte (28).

9. Düsenanordnung (22) nach Anspruch 8, **gekennzeichnet durch** eine Ausnehmung am Düsenkörper (26) zur Aufnahme der Dichtung (74).

10. Düsenanordnung (22) nach einem der Ansprüche 8 oder 9, **dadurch gekennzeichnet, dass** die Dichtung (74) einen runden Querschnitt aufweist.

11. Düsenanordnung (22) nach einem der vorhergehenden Ansprüche, **dadurch gekennzeichnet, dass** die Düsen (36) durch gerade Durchlässe im Düsenkörper (26) gebildet werden, wobei ein Einlassende (50) des Durchlasses höhenmäßig unterhalb eines Auslassendes (51) liegt.

12. Düsenanordnung (22) nach Anspruch 11, **dadurch gekennzeichnet, dass** die Einlassenden (50) der Düsen (36) in eine gemeinsame Verteilerleitung (38) münden, die einen wesentlich größeren Querschnitt als die jeweiligen Düsen (36) aufweist.

13. Düsenanordnung (22) nach Anspruch 12, **dadurch gekennzeichnet, dass** die Einlassenden (50) der (36) Düsen an oder in der Nähe eines höchsten Punktes der Verteilerleitung (38) liegen.

14. Düsenanordnung (22) nach einem der Ansprüche 12 oder 13, **gekennzeichnet durch** eine unterhalb der Verteilerleitung (38) liegende Versorgungsleitung (44), die über eine Vielzahl von Verbindungsleitungen (54) mit der Verteilerleitung (38) verbunden ist.

15. Düsenanordnung (22) nach Anspruch 14, **dadurch gekennzeichnet, dass** die Verbindungsleitungen (54) über die Länge der Verteilerleitung (38) hinweg gleichmäßig beabstandet sind

16. Düsenanordnung (22) nach einem der vorhergehenden Ansprüche, **dadurch gekennzeichnet, dass** wenigsten eine zu den Düsen (36) weisende Oberfläche der Umlenkplatte (28) aus einer hydrophilen Schicht (62) besteht.

17. Düsenanordnung (22) nach einem der vorhergehenden Ansprüche, **gekennzeichnet durch** eine Einrichtung zum Erzeugen einer Relativbewegung zwischen Substrat (2) und Düsenanordnung (22).

18. Düsenanordnung (22) nach Anspruch 17, **dadurch gekennzeichnet, dass** die Einrichtung eine Einheit zum Bewegen der Düsenanordnung (22) im Wesentlichen parallel zur Oberfläche des Substrats (2) aufweist.

19. Düsenanordnung (22) nach Anspruch 17 oder 18, **gekennzeichnet durch** eine Linear-Bewegungseinheit zum Bewegen des Substrats (2) und/oder der Düsenanordnung (22).

20. Düsenanordnung (22) nach Anspruch 18, **dadurch gekennzeichnet, dass** der Düsenkörper (26) und die Umlenkplatte (28) an einem schwenkbaren Arm (32) angebracht sind.

21. Düsenanordnung (22) nach einem der vorhergehenden Ansprüche, **dadurch gekennzeichnet, dass** die Umlenkplatte (28) breiter ist, als das Substrat (2).

22. Düsenanordnung (22) nach einem der vorhergehenden Ansprüche, **dadurch gekennzeichnet, dass** die äußersten Düsen (36) entlang der Linie einen Abstand dazwischen aufweisen, der größer ist als die Breite des Substrats (2).

23. Düsenanordnung (22) nach einem der vorhergehenden Ansprüche, **gekennzeichnet durch** eine Einrichtung (19) zum Einstellen eines Abstands zwischen der Unterkante (64) der Umlenkplatte (28) und dem Substrat (2).

24. Düsenanordnung (22) nach einem der vorhergehenden Ansprüche, **dadurch gekennzeichnet, dass** die Unterkante (64) der Umlenkplatte (28) eine spitze Kante ist.

25. Düsenanordnung (22) nach einem der vorhergehenden Ansprüche, **gekennzeichnet durch** eine Einrichtung zum Öffnen und Schließen von vorbestimmten Düsen, insbesondere außenliegenden Düsen.

26. Düsenanordnung (22) nach einem der vorhergehenden Ansprüche, **dadurch gekennzeichnet, dass** zwischen den Düsen (36) und der Umlenkplatte (28) ein Winkel im Bereich von 90° bis 94°, vorzugsweise zwischen 90,5° und 93° gebildet wird.

27. Düsenanordnung (22) nach einem der vorhergehenden Ansprüche, **dadurch gekennzeichnet, dass** der Winkel zwischen 90,5° und 92° liegt.

## Claims

1. Nozzle arrangement (22) for applying a liquid to a substrate, wherein the nozzle arrangement (22) comprises a nozzle body (26) with a plurality of nozzles (36), which are arranged substantially on a line, and a substantially vertically extending deflecting plate (28) with a straight lower edge (64), and wherein the nozzles (36) are directed above the upper edge (64) onto the deflecting plate (28) so that a liquid film (84) forms on the deflecting plate (28) and flows away over the lower edge (64), wherein formed between nozzle body (26) and deflecting plate (28) is a downwardly widening gap (80) which is : formed by a planar surface. (76) of the nozzle body (26) and the planar surface of the deflecting plate (28), **characterised in that** these are arranged relative to one another at an acute angle (α) between 0.5° and 4° and wherein the planes of the surfaces intersect above the nozzle arrangement in the region of the nozzle body.

2. Nozzle arrangement (22) according to claim 1, **characterised in that** the angle (α) is settable.

3. Nozzle arrangement (22) according to claim 1 or 2, **characterised in that** the angle (α) lies between 1° and 3°.

4. Nozzle arrangement (22) according to claim 3, **characterised in that** the angle (α) lies between 1.5° and 2.5°.

5. Nozzle arrangement (22) according to one of claims 1 to 4, **characterised in that** the planar surface of the deflecting plate (28) extends downwardly away over the planar surface (76) of the nozzle body (26).

6. Nozzle arrangement (22) according to one of the preceding claims, **characterised in that** the deflecting plate (26) is mounted directly at the nozzle body (26).

7. Nozzle arrangement (22) according to claim 6, **characterised in that** the deflecting plate (26) is mounted above the nozzles (36) at the nozzle body (26).

8. Nozzle arrangement (22) according to one of the preceding claims, **characterised by** a seal (74), which lies above the nozzles (36), between nozzle body (26) and deflecting plate (28).

9. Nozzle arrangement (22) according to claim 8, **characterised by** a recess at the nozzle body (26) for reception of the seal (74).

10. Nozzle arrangement (22) according to one of claims 8 and 9, **characterised in that** the seal (74) has a round cross-section.

11. Nozzle arrangement (22) according to one of the preceding claims, **characterised in that** the nozzles (36) are formed by straight passages in the nozzle bodies (26), wherein an inlet end (50) of the passage lies below an outlet end (51) in terms of height.

12. Nozzle arrangement (22) according to claim 11, **characterised in that** the inlet ends (50) of the nozzles (36) open into a common distributor duct (38) which has a substantially greater cross-section than the respective nozzles (36).

13. Nozzle arrangement (22) according to claim 12, **characterised in that** the inlet ends (50) of the nozzles (36) lie at or in the vicinity of a highest point of the distributor duct (38).

14. Nozzle arrangement (22) according to one of claims 12 and 13, **characterised by** a supply duct (44) which lies below the distributor duct (38) and which is connected with a distributor duct (38) by way of a plurality of connecting lines (54).

15. Nozzle arrangement (22) according to claim 14, **characterised in that** the connecting lines (54) are uniformly spaced apart over the length of the distributor duct (38).

16. Nozzle arrangement (22) according to one of the preceding claims, **characterised in that** at least a surface of the deflecting plate (28) facing the nozzles (36) consists of a hydrophilic coating (62).

17. Nozzle arrangement (22) according to one of the preceding claims, **characterised by** a device for producing a relative movement between substrate (2) and nozzle arrangement (22).

18. Nozzle arrangement (22) according to claim 17, **characterised in that** the device comprises a unit for moving the nozzle arrangement (22) substantially parallel to the surface of the substrate (2).

19. Nozzle arrangement (22) according to claim 17 or 18, **characterised by** a linear movement unit for moving the substrate (2) and/or the nozzle arrangement (22).

20. Nozzle arrangement (22) according to claim 18, **characterised in that** the nozzle body (26) and the deflecting plate (28) are mounted at a pivotable arm (32).

21. Nozzle arrangement (22) according to one of the preceding claims, **characterised in that** the deflecting plate (28) is wider than the substrate (2).

22. Nozzle arrangement (22) according to one of the preceding claims, **characterised in that** the outermost nozzles (36) along the line have a spacing therebetween which is greater than the width of the substrate (2).

23. Nozzle arrangement (22) according to one of the preceding claims, **characterised by** a device (19) for setting a spacing between the lower edge (64) of the deflecting plate (28) and the substrate (2).

24. Nozzle arrangement (22) according to one of the preceding claims, **characterised in that** the lower edge (64) of the deflecting plate (28) is a pointed edge.

25. Nozzle arrangement (22) according to one of the preceding claims, **characterised by** a device for opening and closing predetermined nozzles, particularly outwardly disposed nozzles.

26. Nozzle arrangement (22) according to one of the preceding claims, **characterised in that** an angle in the region of 90° to 94°, preferably between 90.5° and 93°, is formed between the nozzles (36) and the deflecting plate (28).

27. Nozzle arrangement (22) according to one of the preceding claims, **characterised in that** the angle lies between 90.5° and 92°.

## Revendications

1. Système de buses (22) pour l'application d'un liquide sur un substrat, où le système de buses (22) présente un corps de buse (26) avec un certain nombre de buses (36) agencées essentiellement sur une ligne et une plaque de retournement (28) s'étendant essentiellement verticalement avec un bord inférieur (64) droit et où les buses (36) sont dirigées au-dessus du bord inférieur (64) sur la plaque de retournement (28), de sorte qu'un film de liquide (84) se forme sur la plaque de retournement (28), qui s'écoule par le bord inférieur (64), où entre le corps de buse (26) et la plaque de retournement (28), une fente (80) s'élargissant vers le bas est formée, qui est constituée d'une surface plane (76) du corps de buse (26) et de la surface plane de la plaque de retournement (28), **caractérisé en ce que** ceux-ci sont agencés l'un par rapport à l'autre, avec un angle aigu (α) allant de 0,5° à 4° et où les plans des surfaces se croisent au-dessus du système de buses au niveau du corps de buse.

2. Système de buses (22) selon la revendication 1, **caractérisé en ce que** l'angle (α) peut être réglé.

3. Système de buses (22) selon la revendication 1 ou 2, **caractérisé en ce que** l'angle (α) se situe dans la gamme allant de 1° à 3°.

4. Système de buses (22) selon la revendication 3, **caractérisé en ce que** l'angle (α) se situe dans la gamme allant de 1,5° à 2,5°.

5. Système de buses (22) selon l'une des revendications 1 à 4, **caractérisé en ce que** la surface plane de la plaque de retournement (28) s'étend vers le bas sur la surface plane (76) du corps de buse (26).

6. Système de buses (22) selon l'une des revendications précédentes, **caractérisé en ce que** la plaque de retournement (26) est fixée directement au corps de buse (26) .

7. Système de buses (22) selon la revendication 6, **caractérisé en ce que** la plaque de retournement (26) est appliquée au-dessus des buses (36) sur le corps de buse (26).

8. Système de buses (22) selon l'une des revendications précédentes, **caractérisé par** une garniture (74) se trouvant au-dessus des buses (36), entre le corps de buse (26) et la plaque de retournement (28).

9. Système de buses (22) selon la revendication 8, **caractérisé par** un creux sur le corps de buse (26) pour la réception de la garniture (74).

10. Système de buses (22) selon l'une des revendications 8 ou 9, **caractérisé en ce que** la garniture (74) présente une section ronde.

11. Système de buses (22) selon l'une des revendications précédentes, **caractérisé en ce que** les buses (36) sont formées par un passage droit dans le corps de buse (26), où une extrémité d'admission (50) du passage se trouve en dessous d'une extrémité de sortie (51).

12. Système de buses (22) selon la revendication 11, **caractérisé en ce que** l'extrémité d'admission (50) des buses (36) débouchent dans une conduite de distribution (38) commune, qui présente une section essentiellement plus grande que chaque buse (36).

13. Système de buses (22) selon la revendication 12, **caractérisé en ce que** l'extrémité d'admission (50) des buses (36) se trouve sur ou à proximité d'un point le plus élevé de la conduite de distribution (38).

14. Système de buses (22) selon l'une des revendications 12 ou 13, **caractérisé par** une conduite d'approvisionnement (44) se trouvant sous la conduite de distribution (38), qui est reliée à la conduite de distribution (38) par une série de conduites de liaison (54) .

15. Système de buses (22) selon la revendication 14, **caractérisé en ce que** les conduites de liaison (54) sont distantes régulièrement sur la longueur de la conduite de distribution (38).

16. Système de buses (22) selon l'une des revendications précédentes, **caractérisé en ce qu'**au moins la surface orientée vers les buses (36), de la plaque de retournement (28) consiste en une couche hydrophobe (62).

17. Système de buses (22) selon l'une des revendications précédentes, **caractérisé par** un dispositif pour produire un mouvement relatif entre le substrat (2) et le système de buses (22).

18. Système de buses (22) selon la revendication 17, **caractérisé en ce que** le dispositif présente une unité pour le mouvement du système de buses (22) de manière essentiellement parallèle à la surface du substrat (2).

19. Système de buses (22) selon la revendication 17 ou 18, **caractérisé par** une unité de mouvement linéaire pour le déplacement du substrat (2) et/ou du système de buses (22).

20. Système de buses (22) selon la revendication 18, **caractérisé en ce que** le corps de buse (26) et la plaque de retournement (28) sont fixés à un bras pivotant (32).

21. Système de buses (22) selon l'une des revendications précédentes, **caractérisé en ce que** la plaque de retournement (28) est plus large que le substrat (2).

22. Système de buses (22) selon l'une des revendications précédentes, **caractérisé en ce que** les buses (36) les plus extérieures sur la ligne présentent une distance entre elles, qui est supérieure à la largeur du substrat (2).

23. Système de buses (22) selon l'une des revendications précédentes, **caractérisé par** un dispositif (19) pour ajuster une distance entre le bord inférieur (64) de la plaque de retournement (28) et le substrat (2).

24. Système de buses (22) selon l'une des revendications précédentes, **caractérisé en ce que** le bord inférieur (64) de la plaque de retournement (28) est un bord pointu.

25. Système de buses (22) selon l'une des revendications précédentes, **caractérisé par** un dispositif pour ouvrir et fermer certaines buses, en particulier les buses extérieures.

26. Système de buses (22) selon l'une des revendications précédentes, **caractérisé en ce qu'**entre les buses (36) et la plaque de retournement (28), un angle allant de 90° à 94°, de préférence de 90,5° à 93°, est formé.

27. Système de buses (22) selon l'une des revendications précédentes, **caractérisé en ce que** l'angle se situe dans l'intervalle allant de 90,5° à 92°.
